# EUROPEAN PATENT SPECIFICATION

(11) **EP 4 152 389 B1**
(45) Date of publication and mention of the grant of the patent: **13.09.2023**
(21) Application number: 22191982.2
(22) Date of filing: 24.08.2022
(51) Int. Cl.: H01L 25/13, G09F 9/33, H01L 25/075, H01L 33/00, H01L 33/52

(54) **METHOD FOR PREPARING A LIGHT-EMITTING DIODE-BASED DISPLAY MODULE**
VERFAHREN ZUR HERSTELLUNG EINES LEUCHTDIODENBASIERTEN ANZEIGEMODULS
PROCÉDÉ DE FABRICATION D'UN MODULE D'AFFICHAGE À BASE DE DIODES ÉLECTROLUMINESCENTES

(30) Priority: 17.09.2021 CN 202111094226
(43) Date of publication of application: 22.03.2023
(73) Proprietor: Leyard Optoelectronic Co., Ltd., Beijing 100091 (CN)
(72) Inventor: ZHENG, Wei, Beijing, 100091 (CN); WANG, Mengqiang, Beijing, 100091 (CN); MA, Li, Beijing, 100091 (CN)
(74) Representative: EDP Patent Attorneys B.V.

(56) References cited:
- EP-A1- 3 736 102
- CN-A- 110 956 902
- CN-A- 113 130 462
- JP-A- H0 922 260
- US-A1- 2020 023 589

## Description

### Cross-Reference to Related Application

The present disclosure claims the priority to Chinese Patent Application No. 202111094226.9, filed to the Chinese Patent Office on September 17, 2021 and entitled "Method for Preparing LED Display Module".

### Technical Field

The present disclosure relates to the technical field of LED display, and in particular to a method for preparing an LED display module.

### Background

With the development of LED display technology, the disclosure of LED display screens is more and more extensive, the pixel pitches of LEDs are getting smaller and smaller, the sizes of LED devices used are also getting smaller and smaller, and the anti-collision, anti-corrosion, moisture-proof and anti-static ability of LED modules are correspondingly required to be stronger and stronger.

In a packaging method of an LED module provided in related art, a circuit board provided with LED lamp beads, a solid light-transmitting glue layer and a light-transmitting film are stacked in sequence, wherein one surface of the circuit board provided with the LED lamp beads faces the light-transmitting film, and a pressure is applied to the circuit board, the light-transmitting glue layer and the light-transmitting film, which are stacked together, in a preset temperature environment, so as to obtain the LED module.

However, in the above-mentioned packaging process, the air existing in lamp slits of the lamp beads cannot be fully exhausted, and the refractive indexes of the light-transmitting glue layer and the light-transmitting film are different from that of the air, resulting in an uneven surface luminescence phenomenon on an LED display surface, which affects the display effect.

US 2020/0023589 A1 discloses a manufacturing process of a display screen cover, and a corresponding display screen. The manufacturing process includes the following steps: S1, providing a lamp panel provided with LED lamp beads; S2, arranging a glue barrier; S3, filling the hollow region of the glue barrier with glue, and covering the LED lamp beads with the glue; S4, providing a press plate; S5, curing the glue; and S6, removing the press plate and the glue barrier. The cover does not need to be additionally assembled on the lamp panel, so that the lamp beads are protected against damage from the cover, and the yield of display screens is increased; and gaps between the lamp beads are completely filled with the cover, so that the lamp beads are fully protected.

### Summary

The purpose of the present invention is to provide a method for preparing an LED display module, so as to solve a problem in related art that air existing in lamp slits of lamp beads cannot be exhausted, thus affecting a display effect.

In order to achieve the above purpose, the present invention provides, in accordance with the appended claim 1, a method for preparing an LED display module, including following steps: step S10: machining a first enclosure around a front surface of a lamp panel, so as to form an accommodating pool on the front surface of the lamp panel; step S30: filling the accommodating pool with glue, and performing a vacuum defoaming treatment on the lamp panel filled with the glue, so as to obtain a defoamed lamp panel; step S40: performing a first curing treatment on the defoamed lamp panel, so as to obtain a lamp panel that has been subjected to the first curing treatment; step S50: removing the first enclosure, and placing the lamp panel with the first enclosure removed in an accommodating appliance, enabling the front surface of the lamp panel with the first enclosure removed to face a bottom of the accommodating appliance, and immersing lamp beads on the lamp panel with the first enclosure removed into defoaming glue in the accommodating appliance, wherein the bottom of the accommodating appliance is a plane portion; step S60: applying an acting force, which faces the bottom of the accommodating appliance, to a back surface of the lamp panel with the first enclosure removed, and immersing the front surface of the lamp panel into the defoaming glue to obtain an immersed lamp panel; and step S70: performing a second curing treatment on the immersed lamp panel, so as to obtain a lamp panel that has been subjected to the second curing treatment, and then the LED display module is obtained.

Further, advantageous embodiments of the present invention are the object of the appended dependent claims.

In some embodiments, between the step S10 and the step S30, the method for preparing the LED display module further includes: step S20: machining a second enclosure around the back surface of the lamp panel.

In some embodiments, the step S30 includes: step S31: filling the accommodating pool with the glue, and performing the vacuum defoaming treatment in a vacuum box on the lamp panel filled with the glue; and step S32: performing the vacuum defoaming treatment for 3 minutes to 10 minutes, so as to obtain the defoamed lamp panel.

In some embodiments, the step S40 includes: step S41: placing the defoamed lamp panel in a curing chamber to perform the first curing treatment, wherein a temperature in the curing chamber is between 20°C and 40°C; and step S42: performing the first curing treatment for 1 hour to 4 hours, so as to obtain the lamp panel that has been subjected to the first curing treatment.

In some embodiments, in the step S42: a viscosity of the glue on the lamp panel that has been subjected to the first curing treatment is between 2000mPa·s and 10000mPa·s.

In some embodiments, the step S50 includes: step S51: fabricating, by using a flexible film, the accommodating appliance capable of accommodating the lamp panel that has been subjected to the first curing treatment; step S52: filling the accommodating appliance with the defoaming glue, so that the accommodating appliance contains the defoaming glue; and step S53: removing the first enclosure, and placing the lamp panel with the first enclosure removed in the accommodating appliance, enabling the front surface of the lamp panel with the first enclosure removed to face the bottom of the accommodating appliance, and immersing the lamp beads on the lamp panel with the first enclosure removed into the defoaming glue.

In some embodiments, in the step S51, the accommodating appliance is placed on a flat plate, so that the bottom of the accommodating appliance forms the plane portion.

In some embodiments, the step S60 includes: step S61: placing a fixture on the back surface of the lamp panel with the first enclosure removed; and step S62: placing a counterweight block above the fixture, so that the fixture applies the acting force, which faces the bottom of the accommodating appliance, to the back surface of the lamp panel with the first enclosure removed, and then the immersed lamp panel is obtained.

In some embodiments, in the step S62, the counterweight block is placed above the fixture, and the counterweight block is fixed on the fixture with an adhesive tape, so that the fixture applies the acting force, which faces the bottom of the accommodating appliance, to the back surface of the lamp panel with the first enclosure removed.

In some embodiments, the step S70 includes: step S71: placing the immersed lamp panel in the curing chamber to perform the second curing treatment, wherein a temperature in the curing chamber is between 20°C and 1000°C; step S72: performing the second curing treatment for 2 hours to 24 hours, so as to obtain the lamp panel that has been subjected to the second curing treatment; and step S73: removing the accommodating appliance, the flat plate and an excess colloid around the lamp panel that has been subjected to the second curing treatment, so as to obtain the LED display module.

In some embodiments, in the step S30, upper surfaces of the lamp beads are immersed into the glue.

In some embodiments, a plurality of electronic devices are arranged on the back surface of the lamp panel, the fixture includes a supporting plate and a plurality of supporting legs that are arranged on a lower surface of the supporting plate at intervals, and the plurality of supporting legs avoid the plurality of electronic devices.

By applying the technical solution of the present disclosure, the method for preparing an LED display module includes the following steps: step S10: machining a first enclosure around a front surface of a lamp panel, so as to form an accommodating pool on the front surface of the lamp panel; step S30: filling the accommodating pool with glue, and performing a vacuum defoaming treatment on the lamp panel filled with the glue, so as to obtain a defoamed lamp panel; step S40: performing a first curing treatment on the defoamed lamp panel, so as to obtain a lamp panel that has been subjected to the first curing treatment; step S50: removing the first enclosure, and placing the lamp panel with the first enclosure removed in an accommodating appliance, enabling the front surface of the lamp panel with the first enclosure removed to face a bottom of the accommodating appliance, and immersing lamp beads on the lamp panel with the first enclosure removed into defoaming glue in the accommodating appliance, at this time, a colloid on the lamp panel with the first enclosure removed is fused with the defoaming glue in the accommodating appliance. Since the two are made of the same material, bubbles are unlikely to be generated at an intersection therebetween, thereby ensuring that no bubble is generated inside a colloid obtained after the second curing treatment, wherein the bottom of the accommodating appliance is a plane portion; step S60: applying an acting force, which faces the bottom of the accommodating appliance, to a back surface of the lamp panel with the first enclosure removed, and immersing the front surface of the lamp panel into the defoaming glue to obtain an immersed lamp panel; and step S70: performing a second curing treatment on the immersed lamp panel, so as to obtain a lamp panel that has been subjected to the second curing treatment, and then an LED display module is obtained. After the step S30, the defoamed lamp panel is obtained, residual air in the front surface of the LED display module is removed, and a probability that surfaces of the lamp beads contact a surface of the colloid to generate bubbles is reduced. Furthermore, glue that has been defoamed is used twice to ensure that no bubble is generated inside the colloid, and at the same time, a probability of generating residual bubbles due to the contact of different objects is greatly reduced, which is conducive to exhausting the air existing in lamp slits of the lamp beads, and improving the display effect of the LED display module. Therefore, the technical solution of the present disclosure effectively solves the problem in related art that the air existing in the lamp slits of the lamp beads cannot be exhausted, thus affecting the display effect. In addition, the bottom of the accommodating appliance is a plane portion, which ensures flatness of the surface of the lamp panel facing the bottom of the accommodating appliance after the first enclosure is removed, and there is no uneven phenomenon.

### Brief Description of the Drawings

The drawings forming a part of the present disclosure are used for providing a further understanding of the present disclosure, and exemplary embodiments of the present disclosure and descriptions thereof are used for explaining the present disclosure, but do not constitute improper limitations of the present disclosure. In the drawings:
Fig. 1 shows a flow diagram of an embodiment of a method for preparing an LED display module according to the present disclosure;
Fig. 2 shows a schematic structural diagram when a front surface of a lamp panel is facing upward in the case where the method for preparing the LED display module shown in Fig. 1 is applied; and
Fig. 3 shows a schematic structural diagram when the front surface of the lamp panel faces a bottom of an accommodating appliance in the case where the method for preparing the LED display module shown in Fig. 1 is applied.

The above drawings include the following reference signs:
1, lamp bead; 2, panel body; 10, first enclosure; 20, second enclosure; 31, accommodating appliance; 32, flat plate; 33, fixture; 34, counterweight block.

### Detailed Description of the Embodiments

A clear and complete description of technical solutions in the embodiments of the present disclosure will be given below, in combination with the drawings in the embodiments of the present disclosure. Apparently, the embodiments described below are merely a part, but not all, of the embodiments of the present disclosure. The following description of at least one exemplary embodiment is merely illustrative and is in no way used as any limitation to the present disclosure and its disclosure or use. All of other embodiments, obtained by those of ordinary skill in the art based on the embodiments of the present disclosure without any creative effort, fall into the protection scope of the present disclosure.

It should be noted that, terms used herein are for the purpose of describing specific embodiments, and are not intended to limit the exemplary embodiments according to the present disclosure. As used herein, unless the context clearly dictates otherwise, a singular form is intended to include a plural form as well. In addition, it should also be understood that, when the terms "comprising" and/or "including" are used in this specification, they indicate that the presence of features, steps, operations, devices, components and/or combinations thereof.

Unless specifically stated otherwise, relative arrangements, numerical expressions and numerical values of components and steps set forth in these embodiments do not limit the scope of the present disclosure. Meanwhile, it should be understood that, for the convenience of description, the dimensions of various portions shown in the drawings are not drawn according to an actual proportional relationship. Techniques, methods and devices known to those of ordinary skill in related art may not be discussed in detail, but where appropriate, such techniques, methods and devices should be considered part of the authorized specification. In all examples shown and discussed herein, any specific value should be construed as illustrative only and not as restrictive. Accordingly, other examples of the exemplary embodiments may have different values. It should be noted that similar reference signs and letters refer to similar items in the following figures, so once a certain item is defined in one figure, it does not require further discussion in subsequent figures.

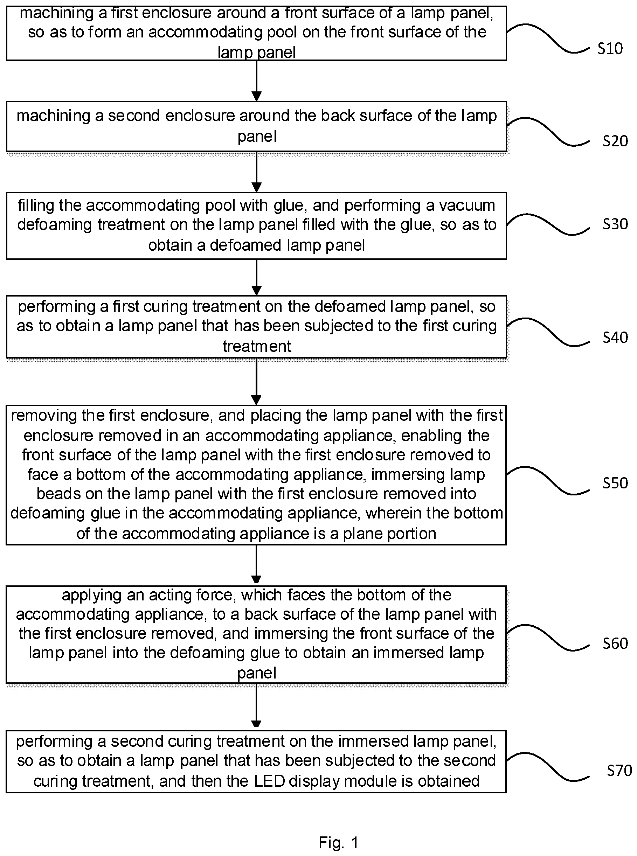

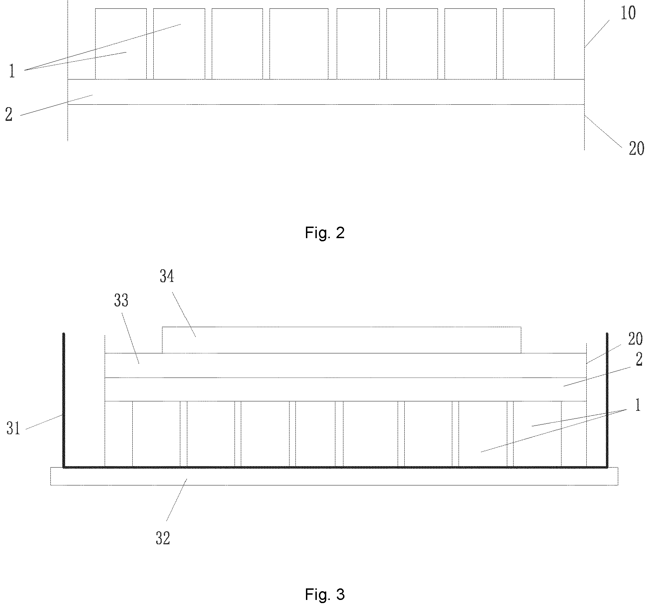

As shown in Fig. 1 to Fig. 3, a method for preparing an LED display module in the present embodiment includes following steps: step S10: machining a first enclosure 10 around a front surface of a lamp panel, so as to form an accommodating pool on the front surface of the lamp panel; step S30: filling the accommodating pool with glue, and performing a vacuum defoaming treatment on the lamp panel filled with the glue, so as to obtain a defoamed lamp panel, wherein the first enclosure 10 blocks the glue so as to prevent the glue from overflowing from the accommodating pool; step S40: performing a first curing treatment on the defoamed lamp panel, so as to obtain a lamp panel that has been subjected to the first curing treatment; in order to prevent interference between the first enclosure 10 and an accommodating appliance 31, step S50: removing the first enclosure 10, and placing the lamp panel with the first enclosure removed in the accommodating appliance 31, enabling the front surface of the lamp panel with the first enclosure removed to face a bottom of the accommodating appliance 31, and immersing lamp beads 1 on the lamp panel with the first enclosure removed into defoaming glue in the accommodating appliance, wherein the bottom of the accommodating appliance 31 is a plane portion; step S60: applying an acting force, which faces the bottom of the accommodating appliance 31, to a back surface of the lamp panel with the first enclosure removed, and immersing the front surface of the lamp panel into the defoaming glue to obtain an immersed lamp panel, wherein since the acting force, which faces the bottom of the accommodating appliance 31, is applied to the back surface of the lamp panel with the first enclosure removed, a colloid on the front surface of the lamp panel with the first enclosure removed is more compact; and step S70: performing a second curing treatment on the immersed lamp panel, so as to obtain a lamp panel that has been subjected to the second curing treatment, and then an LED display module is obtained.

By applying the technical solution of the present disclosure, step S50: removing the first enclosure 10, and placing the lamp panel with the first enclosure removed in the accommodating appliance 31, enabling the front surface of the lamp panel with the first enclosure removed to face the bottom of the accommodating appliance 31, and immersing lamp beads 1 on the lamp panel with the first enclosure removed into defoaming glue in the accommodating appliance 31, at this time, a colloid on the lamp panel with the first enclosure removed is fused with the defoaming glue in the accommodating appliance 31, since the two are made of the same material, bubbles are unlikely to be generated at an intersection therebetween, thereby ensuring that no bubble is generated inside a colloid obtained after the second curing treatment, wherein the bottom of the accommodating appliance 31 is a plane portion; step S60: applying an acting force, which faces the bottom of the accommodating appliance 31, to a back surface of the lamp panel with the first enclosure removed, and immersing the front surface (the front surface of the lamp panel herein specifically refers to a front surface of the panel body 2) of the lamp panel into the defoaming glue to obtain an immersed lamp panel; and step S70: performing a second curing treatment on the immersed lamp panel, so as to obtain a lamp panel that has been subjected to the second curing treatment, and then an LED display module is obtained. After the step S30, the defoamed lamp panel is obtained, residual air in the front surface of the LED display module is removed, and a probability that surfaces of the lamp beads 1 contact a surface of the colloid to generate bubbles is reduced. Furthermore, glue that has been defoamed is used twice to ensure that no bubble is generated inside the colloid, and at the same time, a probability of generating residual bubbles due to the contact of different objects is greatly reduced, which is conducive to exhausting the air existing in lamp slits of the lamp beads 1, and improving the display effect of the LED display module. Therefore, the technical solution of the present embodiment effectively solves the problem in related art that the air existing in the lamp slits of the lamp beads cannot be exhausted, thus affecting the display effect. In addition, the bottom of the accommodating appliance 31 is a plane portion, which ensures flatness of the surface of the lamp panel facing the bottom of the accommodating appliance 31 after the first enclosure is removed, and there is no uneven phenomenon. The lamp panel of the present embodiment includes the panel body 2 and a plurality of lamp beads 1 arranged on the front surface of the panel body. A back surface of the panel body 2 is provided with a plurality of electronic devices.

It should be noted that: the "the front surface of the lamp panel" and "the front surface of the panel body 2" mentioned above refer to surfaces on which the lamp beads are provided. Correspondingly, "the back surface of the lamp panel" and "the back surface of the panel body 2" refer to surfaces on which the lamp beads 1 are not provided.

In the present embodiment, the front surface of the lamp panel with the first enclosure removed is placed downward in the accommodating appliance 31, and the acting force, which faces the bottom of the accommodating appliance, is applied to the lamp panel with the first enclosure removed, so that a smoothness of a front surface of the obtained LED display panel is guaranteed. During a process of directly placing the lamp panel in the accommodating appliance 31, bubbles are easily generated on a contact surface between the defoaming glue and the lamp beads 1, and the lamp panel is inversed placed in the accommodating appliance 31, such that bubbles between adjacent lamp beads 1 are difficult to be discharged. Therefore, filling the glue into the accommodating pool and the first curing treatment are performed at first, so that the lamp beads 1 are entirely wrapped in the colloid without bubbles therein, that is, there is no bubble between the adjacent lamp beads, and then the light panel is put into the accommodating appliance 31. Such an arrangement not only ensures the flatness of the front surface of the LED display module, but also ensures that no bubble exists between adjacent lamp beads 1.

When the lamp panel with the first enclosure removed is put into the accommodating appliance 31, one end of the lamp panel with the first enclosure removed is put into the accommodating appliance 31 at first, and then the lamp panel with the first enclosure removed is slowly lowered down and completely located in the accommodating appliance 31. In this way, when the lamp panel with the first enclosure removed is placed, it is possible to avoid a generation of bubbles on the contact surface between the colloid on the lamp panel and the defoaming glue in the accommodating appliance 31.

In the step S30, the upper surfaces of the lamp beads 1 are immersed into the glue. That is, the glue completely covers the plurality of lamp beads 1 on the front surface of the panel body. In this way, when the step S50 is performed, only the colloid formed on the lamp panel is in contact with the defoaming glue in the accommodating appliance 31, and the lamp beads 1 will not form direct contact with the defoaming glue in the accommodating appliance 31, such that the generation of bubbles is effectively avoided.

As shown in Fig. 1 to Fig. 3, between the step S10 and the step S30, the method for preparing the LED display module further includes: step S20: machining a second enclosure 20 around the back surface of the lamp panel. In this way, the second enclosure 20 blocks the back surface of the lamp panel, so as to prevent the glue or the defoaming glue from flowing to the back surface of the lamp panel.

Specifically, in the present embodiment, the first enclosure 10 and the second enclosure 20 are both adhesive tapes that are made of a PE, PU or an EVA material, and the first enclosure 10 and the second enclosure 20 are bonded to a periphery of the lamp panel.

As shown in Fig. 1 to Fig. 3, the step S30 includes: step S31: filling the accommodating pool with the glue, and performing the vacuum defoaming treatment in a vacuum box on the lamp panel filled with the glue, so as to extract bubbles in the lamp panel filled with the glue; and step S32: performing the vacuum defoaming treatment for 3 minutes to 10 minutes, so as to obtain the defoamed lamp panel. In this way, since the vacuum defoaming treatment is performed for 3 minutes to 10 minutes, the bubbles in the lamp panel filled with the glue are maximally extracted. The time for the vacuum defoaming treatment is preferably 3 minutes or 5 minutes or 8 minutes or 10 minutes.

As shown in Fig. 1 to Fig. 3, the step S40 includes: step S41: placing the defoamed lamp panel in a curing chamber to perform the first curing treatment, wherein a temperature in the curing chamber is between 20°C and 40°C; and step S42: performing the first curing treatment for 1 hour to 4 hours, so as to obtain the lamp panel that has been subjected to the first curing treatment. In this way, after the step S41 and the step S42, a viscosity of the glue on the lamp panel that has been subjected to the first curing treatment is greater and greater to form a sticky colloid, so that when the front surface of the lamp panel that has been subjected to the first curing treatment is placed downward, the glue on the lamp panel will not drop from the lamp panel. The temperature in the curing chamber is preferably 20°C or 30°C or 40°C, and a time for the first curing treatment is preferably 1 hour or 2 hours or 3 hours or 4 hours.

As shown in Fig. 1 to Fig. 3, to ensure that the glue on the lamp panel that has been subjected to the first curing treatment is firmly adhered to the front surface of the lamp panel without dropping, in the step S42: the viscosity of the glue on the lamp panel that has been subjected to the first curing treatment is between 2000mPa·s and 10000mPa s. The viscosity of the glue on the lamp panel that has been subjected to the first curing treatment is preferably 2000mPa·s or 4000mPa·s or 6000mPa·s or 8000mPa·s or 10000mPa s.

As shown in Fig. 1 to Fig. 3, the step S50 includes: step S51: fabricating, by using a flexible film, the accommodating appliance 31 capable of accommodating the lamp panel that has been subjected to the first curing treatment; that is, a volume of the accommodating appliance 31 is greater than that of the lamp panel that has been subjected to the first curing treatment, so that the lamp panel that has been subjected to the first curing treatment completely falls into the accommodating appliance 31. At the same time, in order to ensure no bubble inside the accommodating appliance 31, step S52: filling the accommodating appliance 31 with the defoaming glue, so that the accommodating appliance 31 contains the defoaming glue; and step S53: removing the first enclosure 10, and placing the lamp panel with the first enclosure removed in the accommodating appliance 31, enabling the front surface of the lamp panel with the first enclosure removed to face the bottom of the accommodating appliance 31, and immersing the lamp beads 1 on the lamp panel with the first enclosure removed into the defoaming glue. In this way, in a process of placing the lamp panel with the first enclosure removed into the accommodating appliance 31, the colloid on the lamp panel with the first enclosure removed forms liquid-liquid contact with the defoaming glue, so that the colloid on the lamp panel with the first enclosure removed is completely fused with the defoaming glue, thereby removing the residual air in the front surface of the LED display module as much as possible, and the probability that the surfaces of the lamp beads 1 contact the colloid surface to generate bubbles is thus effectively reduced. A material of the flexible film is preferably PET, PP, PVC, PE or PS. In this way, both surfaces of the flexible film are smooth or one surface is smooth and the other surface is frosted, so as to ensure that a release coating can be formed in advance on a surface of the flexible film that contacts the defoaming glue and the colloid on the lamp panel. Specifically, the release coating is arranged on a contact surface (i.e., an inner surface of the flexible film) of the flexible film with the defoaming glue and the colloid on the lamp panel, so as to facilitate a separation of the flexible film from a cured colloid after the LED display model is prepared.

In the present embodiment, since the inner surface of the flexible film is provided with the release coating, if the glue is first poured into the accommodating appliance 31 and then the vacuum defoaming treatment is performed, the release coating will be separated from the flexible film during the vacuum defoaming treatment, therefore, the accommodating appliance 31 is directly filled with defoaming glue that has been subjected to the vacuum defoaming treatment. When the glue is poured into the accommodating pool, even if the glue is subjected to a defoaming treatment in advance, bubbles are likely to be generated during a contact process of the glue and the surfaces of the lamp beads 1, therefore the glue is filled into the accommodating pool at first, and then the vacuum defoaming treatment is performed.

For LED display modules with different shapes in the related art, a plurality of molds need to be produced, which results in a higher cost. In the present embodiment, in the case of fabricating the accommodating appliance 31 by using the flexible film, the flexible film can be arbitrarily cut, so that it is easy to make a mold shape, and a cost is lower.

As shown in Fig. 1 to Fig. 3, in order to ensure that, after the front surface of the lamp panel with the first enclosure removed is placed facing the bottom of the accommodating appliance 31, the front surface of the lamp panel with the first enclosure removed is smoothly in contact with the bottom of the accommodating appliance 31, in the step S51, the accommodating appliance 31 is placed on a flat plate 32, so that the bottom of the accommodating appliance 31 forms the plane portion.

As shown in Fig. 1 to Fig. 3, the step S60 includes: step S61: placing a fixture 33 on the back surface of the lamp panel with the first enclosure removed; and step S62: placing a counterweight block 34 above the fixture 33, so that the fixture 33 applies an acting force, which faces the bottom of the accommodating appliance 31, to the back surface of the lamp panel with the first enclosure removed, and then the immersed lamp panel is obtained. The fixture 33 is placed on the back surface of the lamp panel with the first enclosure removed, and the counterweight block 34 uniformly applies the acting force, which faces the bottom of the accommodating appliance 31, to the fixture 33, therefore smoothness and uniformity of the colloid on the lamp panel that has been subjected to the second curing treatment are ensured. The fixture 33 includes a supporting plate and a plurality of supporting legs that are arranged on a lower surface of the supporting plate at intervals, the plurality of supporting legs avoid the plurality of electronic devices on the back surface of the lamp panel, that is, the plurality of supporting legs are supported at planar positions on the back surface of the lamp panel. On a premise of avoiding the electronic devices, the supporting legs are provided as many as possible, and the plurality of supporting legs are placed on the back surface of the lamp panel with the first enclosure removed, and when the counterweight block 34 uniformly applies the acting force, which faces the bottom of the accommodating appliance 31, to the fixture 33, a gravity of the counterweight block 34 is sufficiently dispersed, so as to ensure the smoothness and uniformity of the colloid on the lamp panel that has been subjected to the second curing treatment.

It should be noted that, a weight of the counterweight block 34 in the present embodiment can be selected according to requirements for applying counterweight to the lamp panel. Of course, in other feasible embodiments, the supporting legs are directly machined on the counterweight block, so that there is no need to set a fixture, but a production cost of directly machining the supporting legs on the counterweight block is higher.

As shown in Fig. 1 to Fig. 3, in the step S62, the counterweight block 34 is placed above the fixture 33, and to stably place the counterweight block 34 above the fixture 33 without dropping from the fixture 33, the counterweight block 34 is fixed on the fixture 33 with an adhesive tape, so that the fixture 33 applies the acting force, which faces the bottom of the accommodating appliance 31, to the back surface of the lamp panel with the first enclosure removed.

As shown in Fig. 1 to Fig. 3, the step S70 includes: step S71: placing the immersed lamp panel in the curing chamber to perform the second curing treatment, wherein the temperature in the curing chamber is between 20°C and 1000°C; step S72: performing the second curing treatment for 2 hours to 24 hours, so as to obtain the lamp panel that has been subjected to the second curing treatment, at this time, the colloid on the lamp panel that has been subjected to the second curing treatment has cured, thus having higher hardness; and step S73: removing the accommodating appliance 31, the flat plate 32 and an excess colloid around the lamp panel that has been subjected to the second curing treatment, so as to obtain the LED display module. The second enclosure and the adhesive tape are also removed. The manner of removing the excess colloid around the lamp panel can be cutting. The temperature in the curing chamber is preferably 20°C or 30°C or 40°C or 50°C or 60°C or 70°C or 80°C or 90°C or 100°C. The time for the second curing treatment is preferably 2 hours or 5 hours or 8 hours or 10 hours or 12 hours or 15 hours or 18 hours or 20 hours or 24 hours.

In the description of the present disclosure, it should be understood that orientation or position relationships indicated by orientation words such as "front, back, upper, lower, left, right", "transverse, longitudinal, vertical, horizontal" and "top, bottom" and the like are generally orientation or position relationships shown on the basis of the drawings, and are merely for the convenience of describing the present disclosure and simplifying the description, in the absence of opposite statement, these orientation words do not indicate or imply that the referred devices or elements must have specific orientations or must be constructed and operated in specific orientations, and thus cannot be construed as limiting the protection scope of the present disclosure; and the orientation words "inside and outside" refer to the inside and outside of the contours of the components themselves.

For ease of description, spatially relative terms, such as "on", "above", "on the surface", "over" and the like, may be used herein to describe spatial position relationships between one device or feature and other devices or features shown in the figures. It should be understood that, the spatially relative terms are intended to encompass different orientations of the device in use or operation in addition to the orientations depicted in the figures. For example, if the device in the figures is turned over, the device, which is described as "above other devices or features" or "over other devices or features" would then be oriented as "below other devices or features" or "beneath other devices or features". Thus, the exemplary term "above" can encompass both orientations of "above" and "below". The device may also be otherwise oriented (rotated by 90 degrees or at other orientations), and the spatially relative descriptions used herein are interpreted accordingly.

In addition, it should be noted that the terms "first", "second" and the like are used for defining components and parts, and are merely for the convenience of distinguishing the corresponding components and parts, and unless otherwise stated, the above words have no special meaning, and thus cannot be construed as limiting the protection scope of the present disclosure.

The above descriptions are only preferred embodiments of the present disclosure, and are not intended to limit the present disclosure. For those skilled in the art, the present disclosure may have various modifications and changes. The scope of the present invention is defined by the following claims.

## Claims

1. A method for preparing an LED display module, comprising following steps:
step S10: machining a first enclosure (10) around a front surface of a lamp panel, so as to form an accommodating pool on the front surface of the lamp panel;
step S30: filling the accommodating pool with glue, and performing a vacuum defoaming treatment on the lamp panel filled with the glue, so as to obtain a defoamed lamp panel;
step S40: performing a first curing treatment on the defoamed lamp panel, so as to obtain a lamp panel that has been subjected to the first curing treatment;
step S50: removing the first enclosure (10), and placing the lamp panel with the first enclosure removed in an accommodating appliance (31), enabling the front surface of the lamp panel with the first enclosure removed to face a bottom of the accommodating appliance (31), immersing lamp beads (1) on the lamp panel with the first enclosure removed into defoaming glue in the accommodating appliance (31), wherein the bottom of the accommodating appliance (31) is a plane portion;
step S60: applying an acting force, which faces the bottom of the accommodating appliance (31), to a back surface of the lamp panel with the first enclosure removed, and immersing the front surface of the lamp panel into the defoaming glue to obtain an immersed lamp panel; and
step S70: performing a second curing treatment on the immersed lamp panel, so as to obtain a lamp panel that has been subjected to the second curing treatment, and then the LED display module is obtained.

2. The method for preparing the LED display module as claimed in claim 1, wherein between the step S10 and the step S30, the method for preparing the LED display module further comprises:
step S20: machining a second enclosure (20) around the back surface of the lamp panel.

3. The method for preparing the LED display module as claimed in claim 1, wherein the step S30 comprises:
step S31: filling the accommodating pool with the glue, and performing the vacuum defoaming treatment in a vacuum box on the lamp panel filled with the glue; and
step S32: performing the vacuum defoaming treatment for 3 minutes to 10 minutes, so as to obtain the defoamed lamp panel.

4. The method for preparing the LED display module as claimed in claim 1, wherein the step S40 comprises:
step S41: placing the defoamed lamp panel in a curing chamber to perform the first curing treatment, wherein a temperature in the curing chamber is between 20° C and 40° C; and
step S42: performing the first curing treatment for 1 hour to 4 hours, so as to obtain the lamp panel that has been subjected to the first curing treatment.

5. The method for preparing the LED display module as claimed in claim 4, wherein in the step S42: a viscosity of the glue on the lamp panel that has been subjected to the first curing treatment is between 2000mPa • s and 10000mPa • s.

6. The method for preparing the LED display module as claimed in claim 1, wherein the step S50 comprises:
step S51: fabricating, by using a flexible film, the accommodating appliance (31) capable of accommodating the lamp panel that has been subjected to the first curing treatment;
step S52: filling the accommodating appliance (31) with the defoaming glue, so that the accommodating appliance (31) contains the defoaming glue; and
step S53: removing the first enclosure (10), and placing the lamp panel with first enclosure removed in the accommodating appliance (31), enabling the front surface of the lamp panel with the first enclosure removed to face the bottom of the accommodating appliance (31), and immersing the lamp beads (1) on the lamp panel with the first enclosure removed into the defoaming glue.

7. The method for preparing the LED display module as claimed in claim 6, wherein in the step S51, the accommodating appliance (31) is placed on a flat plate (32), so that the bottom of the accommodating appliance (31) forms the plane portion.

8. The method for preparing the LED display module as claimed in claim 1, wherein the step S60 comprises:
step S61: placing a fixture (33) on the back surface of the lamp panel with the first enclosure removed; and
step S62: placing a counterweight block (34) above the fixture (33), so that the fixture (33) applies the acting force, which faces the bottom of the accommodating appliance (31), to the back surface of the lamp panel with the first enclosure removed, and then the immersed lamp panel is obtained.

9. The method for preparing the LED display module as claimed in claim 8, wherein in the step S62, the counterweight block (34) is placed above the fixture (33), and the counterweight block (34) is fixed on the fixture (33) with an adhesive tape, so that the fixture (33) applies the acting force, which faces the bottom of the accommodating appliance (31), to the back surface of the lamp panel with the first enclosure removed.

10. The method for preparing the LED display module as claimed in claim 7, wherein the step S70 comprises:
step S71: placing the immersed lamp panel in a curing chamber to perform the second curing treatment, wherein a temperature in the curing chamber is between 20° C and 1000° C;
step S72: performing the second curing treatment for 2 hours to 24 hours, so as to obtain the lamp panel that has been subjected to the second curing treatment; and
step S73: removing the accommodating appliance (31), the flat plate (32) and an excess colloid around the lamp panel that has been subjected to the second curing treatment, so as to obtain the LED display module.

11. The method for preparing the LED display module as claimed in claim 1, wherein in the step S30, upper surfaces of the lamp beads (1) are immersed into the glue.

12. The method for preparing the LED display module as claimed in claim 8, wherein a plurality of electronic devices are arranged on the back surface of the lamp panel, the fixture (33) comprises a supporting plate and a plurality of supporting legs that are arranged on a lower surface of the supporting plate at intervals, and the plurality of supporting legs avoid the plurality of electronic devices.

## Patentansprüche

1. Verfahren zur Herstellung eines LED-Anzeigemoduls, das die folgenden Schritte umfasst:
Schritt S10: Bearbeiten einer ersten Umfassung (10) um eine Frontfläche eines Lampenpaneels herum, um somit eine Aufnahmeausnehmung an der Frontfläche des Lampenpaneels auszubilden;
Schritt S30: Füllen der Aufnahmeausnehmung mit Klebstoff und Durchführen einer Vakuum-Entschäumungsbehandlung an dem mit dem Klebstoff gefüllten Lampenpaneel, um somit ein entschäumtes Lampenpaneel zu erhalten;
Schritt S40: Durchführen einer ersten Aushärtebehandlung an dem entschäumten Lampenpaneel, um somit ein Lampenpaneel zu erhalten, dass der ersten Aushärtebehandlung unterzogen wurde;
Schritt S50: Entfernen der ersten Umfassung(10), und Platzieren des Lampenpaneels, mit der ersten Umfassung entfernt, in einem aufnehmenden Gerät (31), Ermöglichen, dass die Frontfläche des Lampenpaneels, mit der ersten Umfassung entfernt, einer Unterseite des aufnehmenden Geräts (31) zugewandt ist, Eintauchen von Lampenperlen (1) auf dem Lampenpaneel, mit der ersten Umfassung entfernt, in den entschäumenden Klebstoff in dem aufnehmenden Gerät (31), wobei die Unterseite des aufnehmenden Geräts (31) ein ebener Anteil ist;
Schritt S60: Anwenden einer Wirkkraft, die der Unterseite des aufnehmenden Geräts (31) zugewandt ist, auf eine Rückfläche des Lampenpaneels, mit der ersten Umfassung entfernt, und Eintauchen der Frontfläche des Lampenpaneels in den entschäumenden Klebstoff, um ein eingetauchtes Lampenpaneel zu erhalten; und
Schritt S70: Durchführen einer zweiten Aushärtebehandlung an dem eingetauchten Lampenpaneel, um somit ein Lampenpaneel zu erhalten, dass der zweiten Aushärtebehandlung unterzogen wurde, und dann wird das LED-Anzeigemodul erhalten.

2. Verfahren zur Herstellung des LED-Anzeigemoduls nach Anspruch 1, wobei das Verfahren zur Herstellung des LED-Anzeigemoduls zwischen dem Schritt S10 und dem Schritt S30 ferner umfasst:
Schritt S20: Bearbeiten einer zweiten Umfassung (20) um die Rückfläche des Lampenpaneels herum.

3. Verfahren zur Herstellung des LED-Anzeigemoduls nach Anspruch 1, wobei der Schritt S30 umfasst:
Schritt S31: Füllen der Aufnahmeausnehmung mit dem Klebstoff, und Durchführen der Vakuum-Entschäumungsbehandlung in einer Vakuumkiste an dem mit dem Klebstoff gefüllten Lampenpaneel; und
Schritt S32: Durchführen der Vakuum-Entschäumungsbehandlung für 3 Minuten bis 10 Minuten, um somit das entschäumte Lampenpaneel zu erhalten.

4. Verfahren zur Herstellung des LED-Anzeigemoduls nach Anspruch 1, wobei der Schritt S40 umfasst:
Schritt S41: Platzieren des entschäumten Lampenpaneels in einer Aushärtekammer, um die erste Aushärtebehandlung durchzuführen, wobei eine Temperatur in der Aushärtekammer zwischen 20 °C und 40 °C liegt; und
Schritt S42: Durchführen der ersten Aushärtebehandlung für 1 Stunde bis zu 4 Stunden, um somit das Lampenpaneel zu erhalten, dass der ersten Aushärtebehandlung unterzogen wurde.

5. Verfahren zur Herstellung des LED-Anzeigemoduls nach Anspruch 4, wobei in dem Schritt S42 gilt: eine Viskosität des Klebstoffs auf dem Lampenpaneel, das der ersten Aushärtebehandlung unterzogen wurde, liegt zwischen 2000 mPa•s und 10000 mPa•s.

6. Verfahren zur Herstellung des LED-Anzeigemoduls nach Anspruch 1, wobei der Schritt S50 umfasst:
Schritt S51: Fertigen, unter Verwendung eines flexiblen Films, des aufnehmenden Geräts (31), das dazu fähig ist, das Lampenpaneel, das der ersten Aushärtebehandlung unterzogen wurde, aufzunehmen;
Schritt S52: Füllen des aufnehmenden Geräts (31) mit dem entschäumenden Klebstoff, so dass das aufnehmende Gerät (31) den entschäumenden Klebstoff enthält; und Schritt S53: Entfernen der ersten Umfassung(10), und Platzieren des Lampenpaneels, mit der ersten Umfassung entfernt, in dem aufnehmenden Gerät (31), Ermöglichen, dass die Frontfläche des Lampenpaneels, mit der ersten Umfassung entfernt, der Unterseite des aufnehmenden Geräts (31) zugewandt ist, und Eintauchen der Lampenperlen (1) auf dem Lampenpaneel, mit der ersten Umfassung entfernt, in den entschäumenden Klebstoff.

7. Verfahren zur Herstellung des LED-Anzeigemoduls nach Anspruch 6, wobei in dem Schritt S51, das aufnehmende Gerät (31) auf einer flachen Platte (32) platziert wird, so dass die Unterseite des aufnehmenden Geräts (31) den ebenen Anteil ausbildet.

8. Verfahren zur Herstellung des LED-Anzeigemoduls nach Anspruch 1, wobei der Schritt S60 umfasst:
Schritt S61: Platzieren eines Befestigungselements (33) an der Rückfläche des Lampenpaneels, mit der ersten Umfassung entfernt; und
Schritt S62: Platzieren eines Gegengewichtsblocks (34) über dem Befestigungselement (33), so dass das Befestigungselement (33) die Wirkkraft, die der Unterseite des aufnehmenden Geräts (31) zugewandt ist, auf die Rückfläche des Lampenpaneels, mit der ersten Umfassung entfernt, ausübt, und dann wird das eingetauchte Lampenpaneel erhalten.

9. Verfahren zur Herstellung des LED-Anzeigemoduls nach Anspruch 8, wobei in dem Schritt S62, der Gegengewichtsblock (34) über dem Befestigungselement (33) platziert wird, und wobei der Gegengewichtsblock (34) an dem Befestigungselement (33) mit einem Klebeband befestigt wird, so dass das Befestigungselement (33) die Wirkkraft, die der Unterseite des aufnehmenden Geräts (31) zugewandt ist, auf die Rückfläche des Lampenpaneels, mit der ersten Umfassung entfernt, ausübt.

10. Verfahren zur Herstellung des LED-Anzeigemoduls nach Anspruch 7, wobei der Schritt S70 umfasst:
Schritt S71: Platzieren des eingetauchten Lampenpaneels in einer Aushärtekammer, um die zweite Aushärtebehandlung durchzuführen, wobei eine Temperatur in der Aushärtekammer zwischen 20 °C und 1000 °C liegt;
Schritt S72: Durchführen der zweiten Aushärtebehandlung für 2 Stunden bis zu 24 Stunden, um somit das Lampenpaneel zu erhalten, dass der zweiten Aushärtebehandlung unterzogen wurde; und
Schritt S73: Entfernen des aufnehmenden Geräts (31), der flachen Platte (32) und eines überschüssigen Kolloids um das Lampenpaneel herum, das der zweiten Aushärtebehandlung unterzogen wurde, um somit das LED-Anzeigemodul zu erhalten.

11. Verfahren zur Herstellung des LED-Anzeigemoduls nach Anspruch 1, wobei in dem Schritt S30, obere Flächen der Lampenperlen (1) in den Klebstoff eingetaucht sind.

12. Verfahren zur Herstellung des LED-Anzeigemoduls nach Anspruch 8, wobei eine Vielzahl von elektronischen Bauelementen auf der Rückfläche des Lampenpaneels angeordnet ist, wobei das Befestigungselement (33) eine Trägerplatte und eine Vielzahl von Trägerbeinen, die in Intervallen auf einer tieferen Fläche der Trägerplatte angeordnet sind, und wobei die Vielzahl von Trägerbeinen die Vielzahl von elektronischen Bauelementen vermeidet.

## Revendications

1. Procédé de fabrication d'un module d'affichage à DEL, comprenant les étapes suivantes :
étape S10 : usiner une première enveloppe (10) autour d'une surface avant d'un panneau de lampes, afin de former un récipient de réception sur la surface avant du panneau de lampes ;
étape S30 : remplir le récipient de réception avec de la colle, et effectuer un traitement antimousse sous vide sur le panneau de lampes rempli de colle, afin d'obtenir un panneau de lampes démoussé ;
étape S40 : effectuer un premier traitement de durcissement sur le panneau de lampes démoussé, afin d'obtenir un panneau de lampes qui a été soumis au premier traitement de durcissement ;
étape S50 : retirer la première enveloppe (10) et placer le panneau de lampes dont la première enveloppe a été retirée dans un appareil de réception (31), permettre à la surface avant du panneau de lampes dont la première enveloppe a été retirée de faire face à une partie inférieure de l'appareil de réception (31), immerger des perles de lampe (1), sur le panneau de lampes dont la première enveloppe a été retirée, dans une colle antimousse dans l'appareil de réception (31), la partie inférieure de l'appareil de réception (31) étant une partie plane ;
étape S60 : appliquer une force d'action, qui fait face à la partie inférieure de l'appareil de réception (31), sur une surface arrière du panneau de lampes dont la première enveloppe a été retirée, et immerger la surface avant du panneau de lampes dans la colle antimousse pour obtenir un panneau de lampes immergé ; et
étape S70 : effectuer un deuxième traitement de durcissement sur le panneau de lampes immergé, afin d'obtenir un panneau de lampes qui a été soumis au deuxième traitement de durcissement, ce qui permet d'obtenir le module d'affichage à DEL.

2. Procédé de fabrication du module d'affichage à DEL selon la revendication 1, le procédé de fabrication du module d'affichage à DEL, entre l'étape S10 et l'étape S30, comprenant également :
étape S20 : usiner une deuxième enveloppe (20) autour de la surface arrière du panneau de lampes.

3. Procédé de fabrication du module d'affichage à DEL selon la revendication 1, dans lequel l'étape S30 comprend :
étape S31 : remplir le récipient de réception avec de la colle, et effectuer le traitement antimousse sous vide dans un boîtier sous vide sur le panneau de lampes rempli de colle ; et
étape S32 : effectuer le traitement antimousse sous vide pendant une durée comprise entre 3 minutes et 10 minutes, afin d'obtenir le panneau de lampes démoussé.

4. Procédé de fabrication du module d'affichage à DEL selon la revendication 1, dans lequel l'étape S40 comprend :
étape S41 : placer le panneau de lampes démoussé dans une chambre de durcissement pour effectuer le premier traitement de durcissement, une température dans la chambre de durcissement étant comprise entre 20 °C et 40 °C ; et
étape S42 : effectuer le premier traitement de durcissement pendant une durée comprise entre 1 heure et 4 heures, afin d'obtenir le panneau de lampes qui a été soumis au premier traitement de durcissement.

5. Procédé de fabrication du module d'affichage à DEL selon la revendication 4, dans lequel, à l'étape S42 :
une viscosité de la colle sur le panneau de lampes qui a été soumis au premier traitement de durcissement est comprise entre 2 000 mPa•s et 10 000 mPa•s.

6. Procédé de fabrication du module d'affichage à DEL selon la revendication 1, dans lequel l'étape S50 comprend :
étape S51 : fabriquer, au moyen d'un film souple, l'appareil de réception (31) capable de recevoir le panneau de lampes qui a été soumis au premier traitement de durcissement ;
étape S52 : remplir l'appareil de réception (31) avec la colle antimousse, afin que l'appareil de réception (31) contienne la colle antimousse ; et
étape S53 : retirer la première enveloppe (10) et placer le panneau de lampes dont la première enveloppe a été retirée dans l'appareil de réception (31), permettre à la surface avant du panneau de lampes dont la première enveloppe a été retirée de faire face à la partie inférieure de l'appareil de réception (31), et immerger les perles de lampe (1), sur le panneau de lampes dont la première enveloppe a été retirée, dans la colle antimousse.

7. Procédé de fabrication du module d'affichage à DEL selon la revendication 6, dans lequel, à l'étape S51, l'appareil de réception (31) est placé sur une plaque plate (32), afin que la partie inférieure de l'appareil de réception (31) forme la partie plane.

8. Procédé de fabrication du module d'affichage à DEL selon la revendication 1, dans lequel l'étape S60 comprend :
étape S61 : placer un élément de fixation (33) sur la surface arrière du panneau de lampes dont la première enveloppe a été retirée ; et
étape S62 : placer un bloc de contrepoids (34) par-dessus l'élément de fixation (33), de telle façon que l'élément de fixation (33) applique la force d'action, qui fait face à la partie inférieure de l'appareil de réception (31), à la surface arrière du panneau de lampes dont la première enveloppe a été retirée, ce qui permet d'obtenir le panneau de lampes immergé.

9. Procédé de fabrication du module d'affichage à DEL selon la revendication 8, dans lequel, à l'étape S62, le bloc de contrepoids (34) est placé par-dessus l'élément de fixation (33), et le bloc de contrepoids (34) est fixé sur l'élément de fixation (33) avec un ruban adhésif, de telle façon que l'élément de fixation (33) applique la force d'action, qui fait face à la partie inférieure de l'appareil de réception (31), sur la surface arrière du panneau de lampes dont la première enveloppe a été retirée.

10. Procédé de fabrication du module d'affichage à DEL selon la revendication 7, dans lequel l'étape S70 comprend :
étape S71 : placer le panneau de lampes immergé dans une chambre de durcissement pour effectuer le deuxième traitement de durcissement, une température dans la chambre de durcissement étant comprise entre 20 °C et 1 000 °C ;
étape S72 : effectuer le deuxième traitement de durcissement pendant une durée comprise entre 2 heures et 24 heures, afin d'obtenir le panneau de lampes qui a été soumis au deuxième traitement de durcissement ; et étape S73 : retirer l'appareil de réception (31), la plaque plate (32) et l'excès de colloïde autour du panneau de lampes qui a été soumis au deuxième traitement de durcissement, afin d'obtenir le module d'affichage à DEL.

11. Procédé de fabrication du module d'affichage à DEL selon la revendication 1, dans lequel, à l'étape S30, les surfaces supérieures des parles de lampe (1) sont immergées dans la colle.

12. Procédé de fabrication du module d'affichage à DEL selon la revendication 8, dans lequel une pluralité de dispositifs électroniques est agencée sur la surface arrière du panneau de lampes, l'élément de fixation (33) comprend une plaque de support et une pluralité de branches de support qui sont agencées sur une surface inférieure de la plaque de support à intervalles, et la pluralité de branches de support évite le contact avec la pluralité de dispositifs électroniques.
